(19) Europäisches Patentamt
European Patent Office
Office européen des brevets

(11) EP 2 434 650 A1

(12) **EUROPEAN PATENT APPLICATION**

(43) Date of publication:
**28.03.2012 Bulletin 2012/13**

(51) Int Cl.:
**H03M 13/15** (2006.01)

(21) Application number: **10178821.4**

(22) Date of filing: **23.09.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **Panasonic Corporation**
**Osaka 571-8501 (JP)**

(72) Inventor: **Ratigner, Herve**
**Bristol, BS1 6EA (GB)**

(74) Representative: **Haley, Stephen et al**
**Gill Jennings & Every LLP**
**The Broadgate Tower**
**20 Primrose Street**
**London EC2A 2ES (GB)**

(54) **Reed-Solomon encoder with simplified Galois field multipliers**

(57) A Reed-Solomon encoder contains a bank of k multipliers for multiplying a common feedback value Y by each of the coefficients G0...Gk-1 of the generator polynomial. The processing amount and the circuit size are reduced by calculating once the products of the feedback value with powers of a primitive element alpha, hence yielding partial terms and by using the partial terms in each of the k multipliers. Each multiplier contains an array of AND gates with inputs for the partial products and for the coefficients of the generator polynomial, and contains an array of XOR gates for adding the outputs of the AND gates.

FIGURE 5

EP 2 434 650 A1

**Description**

The present invention relates to the field of Galois Field Multipliers for use in Reed-Solomon (RS) Encoders/ Decoders.

Reed-Solomon encoding is a known method for error detection and correction in data transmission networks. It works by sending an over-sampled set of data containing redundant information. This coding scheme can efficiently reconstruct data symbols which have been, in part, corrupted by up to a specific amount.

A Galois Field multiplier circuit forms the product $A \cdot B$ where " $\cdot$ " is the Galois Field (GF) multiplication operator; the first multiplicand is of magnitude A and the second multiplicand is of magnitude $B$. For practical uses of Reed-Solomon codes, it is common to use a field with $2^N$ elements, in which case each symbol can be represented as an N-bit value.

A Galois Field multiplier circuit has a plurality of constant coefficient multipliers, wherein the first multiplicand is of magnitude $A$ and the second multiplicand is one of a plurality of constants $\alpha^0$, $\alpha^1$, ... , $\alpha^{N-1}$ being the primitive $(2^N -1)$th root of unity in the Galois Field. There are $2^N$ elements in the field, which can be expressed as:

$$0, \alpha^0 = 1, \alpha^1, \alpha^2, ..., \alpha^{2^N-2}$$

the next in the sequence being $\alpha^{2N-1} = 1 = \alpha^0$.

In GF(256), N=8, n=255, a possible field generator polynomial is $p(x) = x^8 + x^4 + x^3 + x^2 + 1$ and $p(\alpha) = \alpha^8 + \alpha^4 + \alpha^3 + \alpha^2 + 1 = 0$.

According to the magnitude $B$, a plurality of selectors enables the outputs of the plurality of constant coefficient multipliers. An additional circuit connected to the selector output performs the addition without carry of the enabled outputs of the plurality of constant coefficient multipliers to form the final product $A \cdot B$.

The additional circuit is implemented using an XOR function:

$$A \bullet B = \sum_{i=0}^{i=N-1} B[i] \cdot \left(A \bullet \alpha^i\right)$$

where the bracketed term $(A \cdot \alpha^i)$ is the plurality of constant coefficient multipliers. The term $B[i]\cdot$ enables the outputs of the plurality of constant coefficient multipliers (one at the time), according to the magnitude $B$ and the bit position i. The expanded version of the expression is:

$$A \bullet B = B[7] \cdot A \bullet \alpha^7 \oplus \cdots \oplus B[1] \cdot A \bullet \alpha^1 \oplus B[0] \cdot A \bullet \alpha^0, \quad for\ N = 8$$

This expanded version represents how a typical GF multiplier is implemented in the prior art.

Applications which use finite field multipliers (such as Reed-Solomon encoders/decoders) comprise several parallel Galois Field multipliers. Typically, to recover "t" erroneous symbols, an RS encoder will need "2t" Galois Field multipliers. A typical Reed-Solomon code (e.g. n = 255, k = 239, t = 8), encodes k = 239 eight-bit data symbols plus 2t = 16 eight-bit parity symbols in an n=255 symbol block. This is denoted as a (n,k) = (255,239) code, and is capable of correcting up to 8 symbol errors per block (each block having n=255 symbols). Thus, the above-described RS code would require 16 multipliers.

The amount of resources required in implementing the 16 multipliers, combined with the delay incurred, is prohibitively costly in an multi-bit architecture reconfigurable device, or for a typical microprocessor, if using the implementation described above.

To address these problems, prior art systems, such as the one disclosed in US patent US-B1-6360348, have been developed which make use of a look-up table (LUT) to provide the products of the plurality of multipliers having a single common input magnitude $Y_m$ to obtain the plurality of products $\{G_0 Y_m, G_1 Y_m, G_2 Y_m, ..., G_{K-1} Y_m\}$.

Whilst the approach is speed efficient and saves computationally expensive operations, this approach is not suitable for reconfigurable devices, where memory units are usually small and scarce.

Accordingly, there is a need for an implementation which is less bulky and more efficient than the expanded implementation outlined above, whilst at the same time being less reliant on large amounts of memory than the LUT-based implementation described above.

In order to solve the problems addressed with the prior art, the present invention provides a Reed Solomon encoder comprising, a variable signal input, an output, means for calculating a plurality of partial terms using signals received at the variable signal input and a plurality of Galois Field multipliers, each Galois Field multiplier comprising, a Reed Solomon encoder coefficient input; means for calculating products of the partial terms with coefficients received at the Reed Solomon encoder coefficient input; and an output arranged to use the calculated products to provide an output signal.As will be appreciated by the skilled reader, the present invention provides several advantages over the prior art. For example, the present invention does not require one Lookup Table (LUT) per Galois field multiplier as it does not lookup all terms but merely the common part of the multiplicand. Moreover, using the present invention, it is possible to change the primitive polynomial by reconfiguring a small number of LUTs held in Random Access Memory (RAM). This method clearly decreases the delay costs of the resulting circuit. This can be achieved because, using the present invention, changing the primitive polynomial consists of merely changing the coefficients that are a function of a single root of the polynomial. Moreover, a change of the primitive polynomial can be effectuated by either by a processor or by another reconfigurable device/circuit, such as D-Fabrix (disclosed in, for example, US6353841 and US2002/0157066).

Preferably, the output of the Reed Solomon encoder is arranged to provide a sum of the Galois Field multipliers outputs.

Preferably, the output signal provided by each Galois Field multiplier output is a sum of the products calculated by that Galois Field multiplier.

Preferably, the variable signal input is arranged to provide a combination of the output of the Reed Solomon encoder and a further input of the Reed Solomon encoder.

Preferably, at least one of the Reed Solomon encoder coefficient inputs is arranged to receive a variable input signal. This has the advantage that the coefficients can be variable and changed without having to redesign/re-optimise an application. In, particular, only the elements holding the coefficients need to be modified and those elements are usually implemented by registers. The change of the coefficients also allows changing the number of multipliers used without redesigning the circuit. This has a direct effect on the number of recoverable erroneous symbols. For example, by simply setting the coefficient to zero, the multiplier output will be zeroed and will not have any effect in the result because the multiplier output is used in additions. A change in the number of multipliers also needs a change in the coefficients used and both changes are possible because the coefficients can be variable (or programmable). This allows us to provide an efficient, flexible system whereas the prior art provides a fixed-coefficient system. This has great advantage over prior art implementations where changing the capability to recover fewer erroneous symbols would require a redesign of the implementation. In the prior art, a redesign is needed because the implementation takes advantage of the constant coefficients and optimizes logic away making it impossible to change the coefficients. The present invention is therefore beneficial when making a programmable encoder, for example, in order to cope with multiple standards, or when some specifications of the encoder are unknown at time of chip fabrication.

Preferably, the means for calculating a plurality of partial terms comprises at least one register located at its output. This has the advantage of providing means for retiming the circuit via the registered output.

Preferably, the means for calculating a plurality of partial terms comprises resources from a reconfigurable array for calculating at least one of the partial terms. Also, preferably, the means for calculating a plurality of partial terms comprises an electronic look up table for calculating at least one of the partial terms. Utilising, a mixture of logic and look-up tables has the advantage that it makes the invention particularly suitable for implementation in a programmable logic array.

Embodiments of the present invention will now be described with reference to the following drawings, in which:

Figure 1 shows a RS encoder in accordance with the prior art;
Figure 2 shows a logical representation of a typical Galois Field multiplier in accordance with the prior art;
Figure 3 shows an expanded physical representation of the typical Galois Field multiplier of Figure 2;
Figure 4 shows a 16 Galois Field multiplier in accordance with the prior art;
Figure 5 shows a 16 Galois Field multiplier in accordance with the present invention; and
Figure 6 shows a functional representation of an 8 bit Reed-Solomon encoder in accordance with the present invention;
Figure 7 shows a full RS encoder (comprising 16 Galois Fields) in accordance with the present invention; and
Figure 8 shows alternative implementations of the present invention.

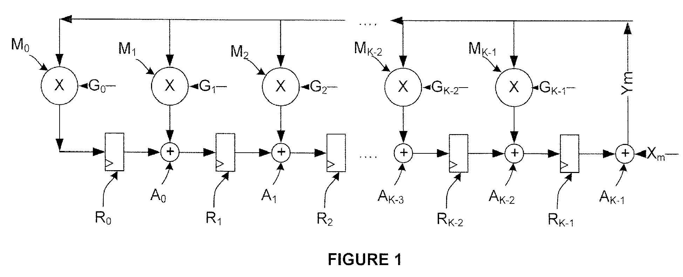

Figure 1 represents a typical RS encoder in accordance with the prior art. The check symbols are calculated over a series of multipliers $M_0$ to $M_{K-1}$ and adders $A_0$ to $A_{K-1}$. These operations are performed sequentially whilst shift registers $R_0$ to $R_{K-1}$ hold the results. Each of the adders and multipliers are finite field operators. The multipliers $M_0$ to $M_{K-1}$ perform multiplication of the feedback signal Ym and the coefficients of the code generating polynomial p(x), Go to $G_{K-1}$. Accordingly, each GF multiplier in a RS encoder will have a feedback input and a coefficient input.

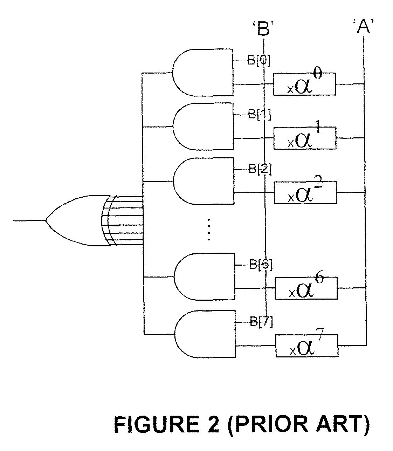

In reference to Figure 2, each Galois field (GF) multiplier implements Z = A•B. In Figure 2, coefficient $\alpha$ is the primitive element of the GF. In its expanded form, the equation representing the circuit of Figure 2 is as follows:

$$Z = B[7] \times A \times \alpha^7 \oplus B[6] \times A \times \alpha^6 \oplus \ldots \oplus B[0] \times A \times \alpha^0$$

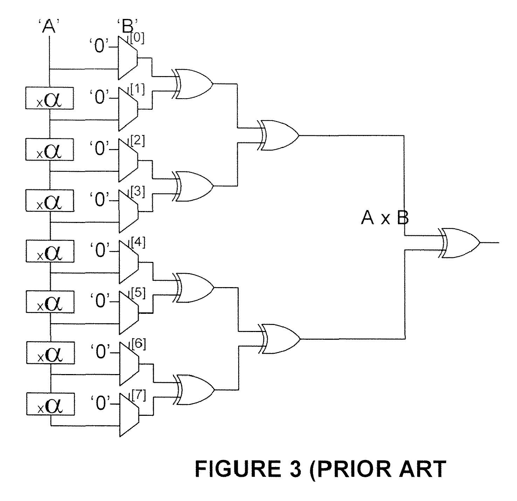

Figure 3 shows a physical representation of the logic gates necessary to implement the above equation.

In order to implement, for example, a Reed-Solomon Encoder, it will be necessary to have a Galois Field comprising several bits, each of which necessitating the use of a dedicated GF multiplier. For example, for an RS encoder having an 8 bit input, the GF used will be $GF(2^8)$, it will be necessary to have 2 * t = 16 multipliers to recover t=8 erroneous symbols with typical RS code (e.g. n=255, k=239, t=8).

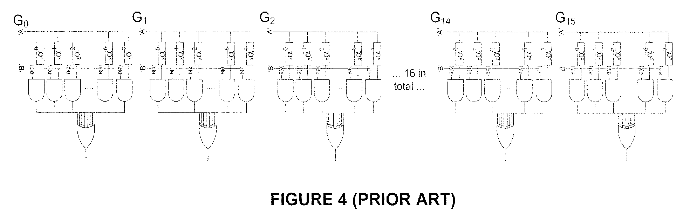

In a conventional implementation of a GF multiplier, the $G_i$ coefficient input is fixed, resulting in the arrangement of Figure 4, where the partial products $G_i \times \alpha^i$ are input into the AND gates. Also, the feedback term of

In order to facilitate the understanding of the present invention, the following mathematical explanation will be provided.

In Galois Fields, "+" is an exclusive-OR (XOR) and "•" is the Galois Field Multiplication. This means that the additive inverse of "a" noted "-a" is "a" because "a XOR a = 0" or simply noted "a + a = 0".

Mathematically, all elements of the $GF(2^N)$ can be expressed as a linear combination of N elements. Accordingly, $\{\alpha^0, \alpha^1, \alpha^2, \alpha^3\ldots, \alpha^{N-2}, \alpha^{N-1}\}$ can be chosen as a base. This base is occasionally expressed as $\{\alpha^{N-1}, \alpha^{N-2}, \ldots, \alpha^2, \alpha^1, \alpha^0\}$.

The base $\{\alpha^{N-1}, \alpha^{N-2},\ldots, \alpha^2, \alpha^1, \alpha^0\}$ or in GF(256), with N = 8, is expressed as $B_8=\{\alpha^7, \alpha^6, \alpha^5, \alpha^4, \alpha^3, \alpha^2, \alpha^1, \alpha^0\}$ and $p(x) = x^8 + x^4 + x^3 + x^2 + 1$ is a field polynomial generator and expressed as $p(\alpha) = \alpha^8 + \alpha^4 + \alpha^3 + \alpha^2 + 1 = 0$ because alpha is a root.

From above it is possible to extract that $\alpha^8= \alpha^4+\alpha^3+\alpha^2+1$. Using this expression, it is possible to compute the following power of $\alpha$ : $\alpha^9= \alpha^{8+1}=\alpha^8\cdot\alpha^1=( \alpha^4+\alpha^3+\alpha^2+1) \cdot\alpha^1$. Then, using the distributivity of multiplication over addition, it is possible to arrive at $\alpha^9= \alpha^5+\alpha^4+\alpha^3+\alpha^1$. Similarly, $\alpha^{10}$ can be expressed as $\alpha^{9+1}=\alpha^9\cdot\alpha^1= (\alpha^5+\alpha^4+\alpha^3+\alpha^1) \cdot \alpha^1 = \alpha^6+\alpha^5+\alpha^4+\alpha^2$, $\alpha^{11}$ as $\alpha^{10+1}=\alpha^{10}\cdot\alpha^1= (\alpha^6+\alpha^5+\alpha^4+\alpha^2) \cdot \alpha^1= \alpha^7+\alpha^6+\alpha^5+\alpha^3$ and $\alpha^{12}$ as $\alpha^{11+1}=\alpha^{11}\cdot\alpha^1= (\alpha^7+\alpha^6+\alpha^5+\alpha^3) \cdot \alpha^1= \alpha^8+\alpha^7+\alpha^6+\alpha^4$.

Using the property that $\alpha^8= \alpha^4+\alpha^3+\alpha^2+1$ it is possible to express $\alpha^{12}$ as $(\alpha^4+\alpha^3+\alpha^2+1)+\alpha^7+\alpha^6+\alpha^4$. Then using the property of associativity (i.e. reordering of the terms), it is possible to express $\alpha^{12}$ as $\alpha^7+\alpha^6+\alpha^4+\alpha^4+\alpha^3+\alpha^2+1$. Because any element is its own additive inverse, $\alpha^4+\alpha^4=0$. Thus, $\alpha^{12}$ becomes $\alpha^7+\alpha^6+\alpha^3+\alpha^2+1$.

Alternatively, because $p(\alpha) = \alpha^8 + \alpha^4 + \alpha^3 + \alpha^2 + 1 = 0$, it is possible to express $\alpha^{12}$ as $\alpha^8+\alpha^7+\alpha^6+\alpha^4+p(\alpha)$, or more usefully, as $\alpha^8+\alpha^7+\alpha^6+\alpha^4 + \alpha^8+\alpha^4+\alpha^3+\alpha^2+1$. Then, using commutativity and additive inverses of $\alpha^8$ and $\alpha^4$, this expression becomes $\alpha^7+\alpha^6+\alpha^3+\alpha^2+1$.

This property is convenient in that, if the term $\alpha^8$ appears in the sum, it is possible to add (or subtract) $p(\alpha)$ and, as $p(\alpha)=0$, the result does not change, though the term $\alpha^8$ can effectively be removed.

Accordingly, using the above technique of reduction, it is possible to show that:

$\alpha^{13}=(\alpha^7+\alpha^6+\alpha^3+\alpha^2+1)\cdot\alpha^1= \alpha^8+\alpha^7+\alpha^4+\alpha^3+\alpha^1 + \alpha^8+\alpha^4+\alpha^3+\alpha^2+1= \alpha^7+\alpha^2+\alpha^1+1$,
$\alpha^{11}= (\alpha^7+\alpha^2+\alpha^1+1)\cdot\alpha^1= \alpha^8+\alpha^3+\alpha^2+\alpha^1 + \alpha^8+\alpha^4+\alpha^3+\alpha^2+1= \alpha^4+\alpha^1+1$,
$\alpha^{15}=(\alpha^4+\alpha^1+1)\cdot\alpha^1= \alpha^5+\alpha^2+\alpha^1$, and
$\alpha^{16}=(\alpha^5+\alpha^2+\alpha^1)\cdot\alpha^1= \alpha^6+\alpha^3+\alpha^2$.

The inventor of the present invention has realised that the above mathematical properties can be taken advantage of when implementing a plurality of GF multipliers in an encoder.

As shown above, it is possible to express all the elements of GF(256) as a linear combination in base $B_8$ as $\{\alpha^7, \alpha^6, \alpha^5, \alpha^4, \alpha^3, \alpha^2, \alpha^1, \alpha^0\}$. Effectively, when expressed using this base, 1 = {0,0,0,0,0,0,0,1}, $\alpha$= {0,0,0,0,0,0,1,0}, $\alpha^2$= {0,0,0,0, 0,1,0,0}, $\alpha^3$= {0,0,0,0,1,0,0,0}, and so on.

When concatenating all the 1's and 0's, it is possible to express the bit string as a hexadecimal number, as follows:

$$1 = \{0,0,0,0,0,0,0,1\} = 0x01,$$

$$\alpha = \{0,0,0,0,0,0,1,0\} = 0x02,$$

$$\alpha^2 = \{0,0,0,0,0,1,0,0\} = 0x04,$$

$$\alpha^3 = \{0,0,0,0,1,0,0,0\} = 0x08, [\ldots]$$

$$\alpha^8 = \alpha^4 + \alpha^3 + \alpha^2 + 1 = \{0,0,0,1,1,1,0,1\} = 0x1d$$

Thus, in general terms, an element c of GF(256) can be expressed in base $B_8$ as the following linear combination:

$$c = \{c_7, c_6, c_5, c_4, c_3, c_2, c_1, c_0\}, \text{ with } c_i \text{ being either a 0 or a 1}$$

$$c = c_7\alpha^7 + c_6\alpha^6 + c_5\alpha^e + c_4\alpha^4 + c_3\alpha^3 + c_2\alpha^2 + c_1\alpha^1 + c_0$$

If then multiplied by $\alpha$, it is possible to arrive at:

$$c \bullet \alpha^1 = (c_7\alpha^7 + c_6\alpha^6 + c_5\alpha^5 + c_4\alpha^4 + c_3\alpha^3 + c_2\alpha^2 + c_1\alpha^1 + c_0) \bullet \alpha^1$$

$$c \bullet \alpha^1 = c_7\alpha^8 + c_6\alpha^7 + c_5\alpha^6 + c_4\alpha^5 + c_3\alpha^4 + c_2\alpha^3 + c_1\alpha^2 + c_0\alpha^1$$

At this stage note that there are no terms in $\alpha^0$. If $c_7=0$ no further processing is needed, thus $c \bullet \alpha^1$ can be expressed as $\{c_6, c_5, c_4, c_3, c_2, c_1, c_0, 0\}$, or $c \bullet \alpha^1 = c<<1$. If $c_7 = 1$ then some processing is needed and so, as described above, the field generator polynomial $p(\alpha) = 0$ is added to the expression and it becomes $c \bullet \alpha^1 = c_7\alpha^8 + c_6\alpha^7 + c_5\alpha^6 + c_5\alpha^5 + c_3\alpha^4 + c_2\alpha^3 + c_1\alpha^2 + c_0\alpha^1 + p(\alpha)$.

As $c_7=1$ the expression can also be expressed as:

$c \bullet \alpha^1 = c_7\alpha^8 + c_6\alpha^7 + c_5\alpha^6 + c_4\alpha^5 + c_3\alpha^4 + c_2\alpha^3 + c_1\alpha^2 + c_0\alpha^1 + c_7p(a)$ which also covers the case where $c_7=0$. Replacing $c_7p(\alpha)$ by $c_7(\alpha^8 + \alpha^4 + \alpha^3 + \alpha^2 + 1)$, it is possible to obtain:

$$c \bullet \alpha^1 = c_7\alpha^8 + c_6\alpha^7 + c_5\alpha^6 + c_4\alpha^5 + c_3\alpha^4 + c_2\alpha^3 + c_1\alpha + c_0\alpha^1 + c_7(\alpha^8 + \alpha^4 + \alpha^3 + \alpha^2 + 1)$$

Then, using distributivity of multiplication over addition, it is possible to arrive at:

$$c \bullet \alpha^1 = c_7\alpha^8 + c_6\alpha^7 + c_5\alpha^6 + c_4\alpha^5 + c_3\alpha^4 + c_2\alpha^3 + c_1\alpha^2 + c_0\alpha^1 + c_7\alpha^8 + c_7\alpha^4 + c_7\alpha^3 + c_7\alpha^2 + c_7$$

Finally, using commutativity and distributivity of multiplication over addition, it is possible to arrive at:

$$c \bullet \alpha^1 = c_7\alpha^8 + c_7\alpha^8 + c_6\alpha^7 + c_5\alpha^6 + c_4\alpha^5 + c_3\alpha^4 + c_7\alpha^4 + c_2\alpha^3 + c_7\alpha^3 + c_1\alpha^2 + c_7\alpha^2 + c_0\alpha^1 + c_7$$

$$c \bullet \alpha^1 = c_7(\alpha^8 + \alpha^8) + c_6\alpha^7 + c_5\alpha^6 + c_4\alpha^5 + (c_3 + c_7)\alpha^4 + (c_2 + c_7)\alpha^3 + (c_1 + c_7)\alpha^2 + c_0\alpha^1 + c_7$$

or as $\alpha^8 + \alpha^8 = 0$, in base $B_8$ as $c = \{c_6, c_5, c_4, c_3 + c_7, c_2 + c_7, c_1 + c_7, c_0, c_7\}$, $c \bullet \alpha^1 = (c<<1)$ XOR $c_7.0x11d$.

This general formula is used in the hardware implementation of the present invention when the field generator polynomial is

$$p(x) = x^8 + x^4 + x^3 + x^2 + 1.$$

Accordingly, generic multiplication of GF(256) can be expressed as follows:

$$c=\{c_7,c_6,c_5,c_4,c_3,c_2,c_1,c_0\}$$

$$d=\{d_7,d_6,d_5,d_4,d_3,d_2,d_1,d_0\}$$

Using the distributivity of multiplication over addition (distributing the multiplication c• over the addition $d=d_7\alpha^7+d_6\alpha^6+d_5\alpha^e+d_4\alpha^4+d_3\alpha^3+d_2\alpha^2+d_1\alpha^1+d_0$): $c\bullet d=c\bullet d_7\alpha^7+c\bullet d_6\alpha^6+c\bullet d_5\alpha^5+c\bullet d_4\alpha^4+c\bullet d_3\alpha^3+c\bullet d_2\alpha^2+c\bullet d_1\alpha^1+c\bullet d_0\alpha^0$ $c\bullet d=d_7 c\bullet\alpha^7+d_6 c\bullet\alpha^6+d_5 c\bullet\alpha^5+d_4 c\bullet\alpha^4+d_3 c\bullet a^3+d_2 c\bullet\alpha^2+d_1 c\bullet\alpha^1+d_0 c\bullet\alpha^0$ (which will now be referred to as EXP1)

The expression clearly shows that the product c•d is the linear combination of the terms $\{c\bullet\alpha^7, c\bullet\alpha^6, c\bullet\alpha^5, c\bullet\alpha^4, c\bullet\alpha^3, c\bullet\alpha^2, c\bullet\alpha^1, c\bullet\alpha^0\}$ according to the magnitude "d".

The terms $c\bullet\alpha^i$ can be obtained by several methods (e.g. using LUTs or by using the known relation $c\bullet\alpha^{i+1}=c\bullet\alpha^i\bullet\alpha^1$, as used above). Because of the commutativity of the multiplication, $c\bullet d=d\bullet c$, and distributing the multiplication d• over the addition $c = c_7\alpha^7+c_6\alpha^6+c_5\alpha^e+c_4\alpha^4+c_3\alpha^3+c_2\alpha^2+c_1\alpha^1+c_0$ results in:

$$c\bullet d=d\bullet c=c_7 d\bullet\alpha^7+c_6 d\bullet\alpha^6+c_5 d\bullet\alpha^5+c_4 d\bullet\alpha^4+c_3 d\bullet a^3+c_2 d\bullet\alpha^2+c_1 d\bullet\alpha^1+c_0 d\bullet\alpha^0 \text{ (which will now be referred to as EXP2)}$$

This shows that GF multiplier implementations can have their inputs swapped and they will still produce the same mathematical result, as EXP2 is equivalent to EXP1.

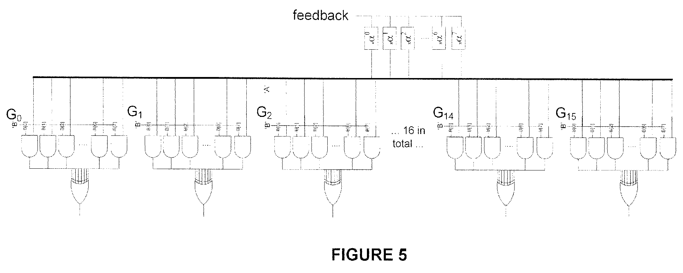

Now, with reference to Figure 5, an embodiment of the present invention will now be described.

First, in the prior art and Figure 4, $G_0$, $G_1$... $G_{K-1}$ is connected to c and Ym is connected to d (as disclosed above). It is possible to identify the terms to EXP1: the common feedback Ym connecting to all the hardware inputs "B", or d from EXP1 and $G_0$, $G_1$... $G_{K-1}$ connecting to c from EXP1/HW input "A" of each multiplier.

According to the present invention, swapping the inputs is equivalent to using EXP2 to describe what is happening: $G_0$, $G_1$... $G_{K-1}$ still connect to c and Ym still connects to d (again, as disclosed above) for the multipliers in the "mathematics", however the hardware connections of the inputs has been swapped.. hence the use of EXP2.

The invention takes advantage of the description EXP2, which is effectively swapping the inputs of the multipliers.

If using EXP2, Ym connects to the input d and the set of partial products $PP=\{d\bullet\alpha^7, d\bullet\alpha^6, d\bullet\alpha^5, d\bullet\alpha^4, d\bullet\alpha^3, d\bullet\alpha^2, d\bullet\alpha^1, d\bullet\alpha^0\}$ is the same across the plurality of GF multipliers. Now the set of magnitudes $G_0$, $G_1$... $G_{K-1}$ is used to selectively enable the outputs of the plurality of multipliers to form the final product.

$G0\bullet d=G0_7 d\bullet\alpha^7+G0_6 d\bullet\alpha^6+G0_5 d\bullet\alpha^5+G0_4 d\bullet\alpha^4+G0_3 d\bullet\alpha^3+G0_2 d\bullet\alpha^2+G0_1 d\bullet\alpha^1+G0_0 d\bullet\alpha^0$

$G1\bullet d=G1_7 d\bullet\alpha^7+G1_6 d\bullet\alpha^6+G1_5 d\bullet\alpha^5+G1_4 d\bullet\alpha^4+G1_3 d\bullet\alpha^3+G1_2 d\bullet\alpha^2+G1_1 d\bullet\alpha^1+G1_0 d\bullet\alpha^0$

$G2\bullet d=G2_7 d\bullet\alpha^7+G2_6 d\bullet\alpha^6+G2_5 d\bullet\alpha^5+G2_4 d\bullet\alpha^4+G2_3 d\bullet\alpha^3+G2_2 d\bullet\alpha^2+G2_1 d\bullet\alpha^1+G2_0 d\bullet\alpha^0$

The final product is comprised of similar expressions from GK-1(or G15), for a total of K (or 16) terms. This implementation returns $Y_m\bullet\alpha^i$, which are partial terms, used to derive the plurality of products $\{G_0 Y_m, G_1 Y_m, G_2 Y_m,..., G_{K-1} Y_m\}$.

In order to implement a GF multiplier in accordance with the present invention, the inputs of the multiplier of Figure 4 are swapped. The coefficients $g_i$ are connected to the B input of each multiplier respectively and the common feedback term connects to the A input. Accordingly, $B\bullet A\alpha$ becomes $A\bullet B\alpha$.

As shown in Figure 5, the circuit of the present invention provides a feedback signal which is common to all $\alpha$ blocks. Thus, in this implementation, a common term is used in the computation of $\alpha$ and is therefore shared by all multipliers. Some, or all, of the multiply by $\alpha^n$ blocks can be implemented using LUTs. As will be appreciated, this implementation will require, at most, n LUTs (where $GF(2^n)$) and is not dependant on the number of correctable errors.

Accordingly, the circuit shown in Figure 5 allows configuration of the Reed Solomon encoder coefficients applied to the multipliers and therefore the number of multipliers utilised can be changed without changing the implementation of the circuit. This provides an encoder circuit which is particularly flexible, for example, the number of multipliers utilised could be reduced from 16 multipliers to 8 multipliers by setting eight of the multiplier coefficients to zero. Accordingly, this would change the number of recoverable erroneous symbols from the encoded data from 8 to 4.

As will be appreciated, in order to implement the present invention, it will be necessary to clock the outputs of the each GF multiplier, thereby turning the combinatorial function of the prior art into the registered function of the present invention.

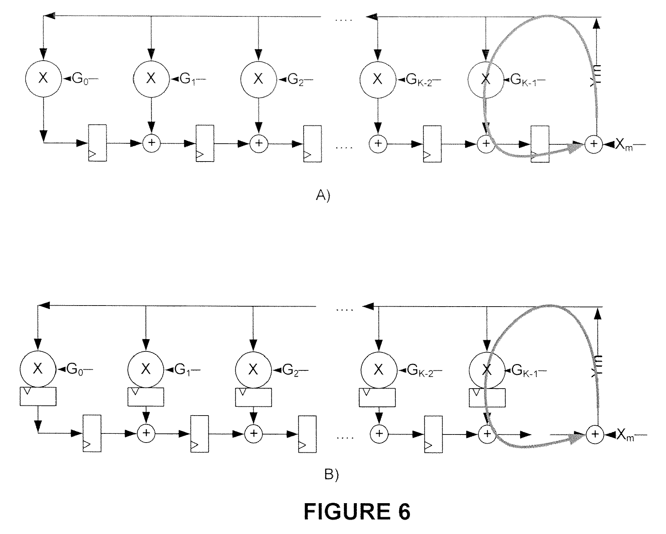

Figure 6 represents a comparative diagram of an encoder in accordance with the prior art and an encoder in accordance with the present invention.

As can be seen from Figure 6A, in the device of the prior art, the multipliers are combinatorial functions, whereas Figure 6B shows that in the present invention, the multipliers become registered functions. It can also be seen however that both circuits have the same number of registers in any given feedback loop. Accordingly, the circuits will conserve the same functionality.

The embodiment shown Figure 6B takes advantage of a technique known as retiming. As would be appreciated by those skilled in the art, retiming technique is typically used on a function that has all its inputs registered or all its outputs registered. There are two types of transformation operations that can be performed. A first operation for when all inputs are registered and a second operation for when all outputs are registered. For example, the second operation removes one register from all the outputs and add registers on all its inputs. The first operation works the other way around by removing one register from all the inputs and adding one register on all its outputs.

In Figure 6B the second operation has been applied. This does not change the functionality of the overall circuit and has the advantage of reducing the critical path or combinatorial functions between sets of registers. This could be implemented in the circuit of Figure 5 by having a register located at each of the outputs of the common circuit block calculating the partial terms. Alternatively, registers could be provided at the inputs of each Galois field multiplier (e.g. at the inputs to the AND gates connected to the outputs of the conmmon circuit block).

The advantage of the present invention is that in the new arrangement, the registered multipliers can be implemented using look-up-tables or synchronous RAMs (or be kept as logic with registered output). This not only reduces the critical path but also reduces the number of resources used.

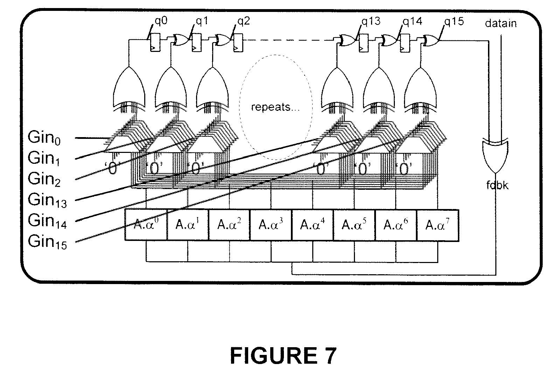

Figure 7 shows an 8 bit Reed-Solomon encoder in accordance with the present invention. As described above, the present invention can be used in several applications. However, as will be appreciated, the mixture of LUT and logic which is required for the present invention makes it ideal for arrays of programmable logic.

Moreover, the present invention is particularly well suited for applications where the Galois Field is $GF(2^n)$, where n is of a comparatively small value. The above description uses n=8, though other values are clearly possible. For a given n, it will be necessary to have M LUTs, M being the number of multipliers needed to generate (i.e. produce) the partial product terms (i.e. $A \cdot \alpha^i$) implemented using a LUT. As described above, i=0 is the identity function and does not require any logic and i=1 is easily implemented using conventional logic. Accordingly, M will be equal to n-2, each LUT having $n \cdot 2^n$ bits, thereby totalling $(n-2) \cdot n \cdot 2^n$ memory bits. For example, for n=8, 12kbits of memory will be needed to implement the present invention.

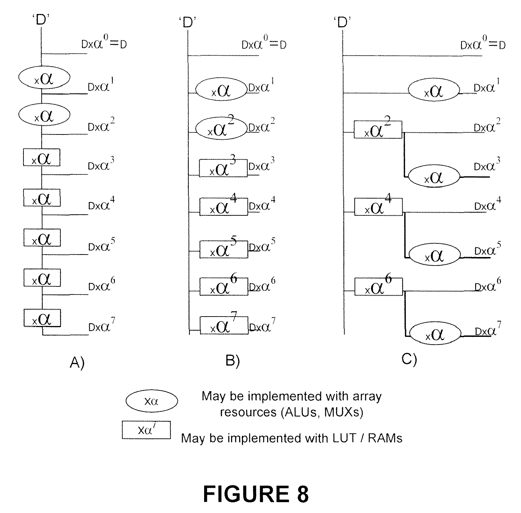

The set of figures labelled in Figure 8 represent examples of the generation of the partial products in relation with the present invention. In the description the partial products $PP=\{d \cdot \alpha^7, d \cdot \alpha^6, d \cdot \alpha^5, d \cdot \alpha^4, d \cdot \alpha^3, d \cdot \alpha^2, d \cdot \alpha^1, d \cdot \alpha^0\}$ are shared across the plurality of GF multipliers. In the implementation the outputs of this block are registered but as already described some registers could be further moved around using the retiming technique.

Figure 8A represents a particular embodiment of the present invention, where each of the first GF multiplier by coefficient $\alpha$ is implemented using resources from the reconfigurable array (e.g. Arithmetic Logic Units and Multiplexers) on which the RS encoder is being implemented. Also, the remaining $\alpha$ are can be implemented with a single type of LUT. As can be seen, the longest critical path would be the path finishing at $d \cdot \alpha$ but this is advantageous because only one type of LUT is used multiple times. The registers would be on the outputs busses $d \cdot \alpha^i$ but are not drawn for simplicity.

Figure 8B represents another particular embodiment of the present invention, where each of the first GF multiplier by coefficient $\alpha$ is implemented using resources from the reconfigurable array and each of the remaining multiplier by coefficients $\alpha^i$ (i.e. $\alpha^3, \alpha^4 ... \alpha^7$) are implemented using a dedicated LUT. Accordingly, this embodiment will comprise 5 LUTs or, alternatively, a large single LUT. The amount of LUTs in thise embodiment is a fraction of what the prior art implementations would require, as that may need up to 16 LUTs. Here, all the LUTs have registers on their outputs and as described earlier could be implemented with synchronous RAMs.

Figure 8C represents another particular embodiment of the present invention where four GF multipliers by $\alpha$ are implemented using resources from the reconfigurable array and each of the remaining coefficients $\alpha$ (i.e. $\alpha^2, \alpha^4$ and $\alpha^6$) are implemented using a dedicated LUT. Accordingly, this embodiment will comprise 3 LUTs. There is a trade-off between the number of LUT required and the combinatorial path length on the outputs for D times $\alpha^3, \alpha^5, \alpha^7$ compared to the similar outputs of Figure 8B. Here again, all the LUTs have registers on their outputs and as described earlier could be implemented with synchronous RAMs.

## Claims

1. A Reed Solomon encoder comprising, a variable signal input, an output, means for calculating a plurality of partial terms using signals received at the variable signal input and a plurality of Galois Field multipliers, each Galois Field multiplier comprising:

   a Reed Solomon encoder coefficient input;
   means for calculating products of the partial terms with coefficients received at the Reed Solomon encoder coefficient input; and

an output arranged to use the calculated products to provide an output signal.

2. A Reed Solomon encoder according to claim 1 wherein the output of the Reed Solomon encoder is arranged to provide a sum of the Galois Field multipliers outputs.

3. A Reed Solomon encoder according to any preceding claim wherein the output signal provided by each Galois Field multiplier output is a sum of the products calculated by that Galois Field multiplier.

4. A Reed Solomon encoder according to any preceding claim, wherein the variable signal input is arranged to provide a combination of the output of the Reed Solomon encoder and a further input of the Reed Solomon encoder.

5. A Reed Solomon encoder according to any preceding claim wherein at least one of the Reed Solomon encoder coefficient inputs is arranged to receive a variable input signal.

6. A Reed Solomon encoder according to any preceding claim wherein the means for calculating a plurality of partial terms comprises at least one register located at its output.

7. A Reed Solomon encoder according to any preceding claim wherein the means for calculating a plurality of partial terms comprises resources from a reconfigurable array for calculating at least one of the partial terms.

8. A Reed Solomon encoder according to any preceding claim wherein the means for calculating a plurality of partial terms comprises at least one electronic look up table for calculating at least one of the partial terms.

**FIGURE 1**

'B'    'A'

B[0]    $_x\alpha^0$

B[1]    $_x\alpha^1$

B[2]    $_x\alpha^2$

⋮

B[6]    $_x\alpha^6$

B[7]    $_x\alpha^7$

# FIGURE 2 (PRIOR ART)

FIGURE 3 (PRIOR ART

FIGURE 4 (PRIOR ART)

EP 2 434 650 A1

FIGURE 5

13

A)

B)

FIGURE 6

# FIGURE 7

'D'
$Dx\alpha^0 = D$
$x\alpha$   $Dx\alpha^1$
$x\alpha$   $Dx\alpha^2$
$x\alpha$   $Dx\alpha^3$
$x\alpha$   $Dx\alpha^4$
$x\alpha$   $Dx\alpha^5$
$x\alpha$   $Dx\alpha^6$
$x\alpha$   $Dx\alpha^7$

A)

'D'
$Dx\alpha^0 = D$
$x\alpha$   $Dx\alpha^1$
$x\alpha^2$   $Dx\alpha^2$
$x\alpha^3$   $Dx\alpha^3$
$x\alpha^4$   $Dx\alpha^4$
$x\alpha^5$   $Dx\alpha^5$
$x\alpha^6$   $Dx\alpha^6$
$x\alpha^7$   $Dx\alpha^7$

B)

'D'
$Dx\alpha^0 = D$
$x\alpha$   $Dx\alpha^1$
$x\alpha^2$   $Dx\alpha^2$
$x\alpha$   $Dx\alpha^3$
$x\alpha^4$   $Dx\alpha^4$
$x\alpha$   $Dx\alpha^5$
$x\alpha^6$   $Dx\alpha^6$
$x\alpha$   $Dx\alpha^7$

C)

$x\alpha$   May be implemented with array resources (ALUs, MUXs)

$x\alpha^i$   May be implemented with LUT / RAMs

# FIGURE 8

Europäisches
Patentamt

European
Patent Office

Office européen
des brevets

## EUROPEAN SEARCH REPORT

Application Number

EP 10 17 8821

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/090119 A1 (DONG QIUJIE [US] ET AL) 27 April 2006 (2006-04-27) * paragraph [0040] - paragraph [0051] * * paragraph [0058] * * figures 1, 3 * | 1-8 | INV. H03M13/15 |
| A | US 5 818 855 A (FOXCROFT THOMAS [GB]) 6 October 1998 (1998-10-06) * column 7; figure 10 * | 1-8 | |
| X | US 7 178 091 B1 (ALON MOSHE [IL]) 13 February 2007 (2007-02-13) * column 2, line 40 - line 10; figures 1,2 * | 1-8 | |
| A | WO 91/20028 A1 (MASTROVITO EDOARDO [SE]) 26 December 1991 (1991-12-26) * abstract * | 1-8 | |

TECHNICAL FIELDS
SEARCHED      (IPC)

G06F
H03M

The present search report has been drawn up for all claims

| Place of search | Date of completion of the search | Examiner |
|---|---|---|
| Munich | 18 January 2011 | Farman, Thomas |

EPO FORM 1503 03.82 (P04C01)

EP 2 434 650 A1

**ANNEX TO THE EUROPEAN SEARCH REPORT
ON EUROPEAN PATENT APPLICATION NO.**

EP 10 17 8821

This annex lists the patent family members relating to the patent documents cited in the above-mentioned European search report.
The members are as contained in the European Patent Office EDP file on
The European Patent Office is in no way liable for these particulars which are merely given for the purpose of information.

18-01-2011

| Patent document cited in search report | | Publication date | Patent family member(s) | | Publication date |
|---|---|---|---|---|---|
| US 2006090119 | A1 | 27-04-2006 | US | 2008155382 A1 | 26-06-2008 |
| US 5818855 | A | 06-10-1998 | AU | 699253 B2 | 26-11-1998 |
| | | | AU | 3991897 A | 07-05-1998 |
| | | | CA | 2199114 A1 | 30-04-1998 |
| | | | CN | 1181664 A | 13-05-1998 |
| | | | EP | 0840461 A2 | 06-05-1998 |
| | | | ID | 18695 A | 30-04-1998 |
| | | | JP | 10177497 A | 30-06-1998 |
| | | | SG | 65026 A1 | 25-05-1999 |
| US 7178091 | B1 | 13-02-2007 | NONE | | |
| WO 9120028 | A1 | 26-12-1991 | AU | 8076591 A | 07-01-1992 |
| | | | SE | 466822 B | 06-04-1992 |
| | | | SE | 9002124 A | 16-12-1991 |

EPO FORM P0459

For more details about this annex : see Official Journal of the European Patent Office, No. 12/82

## REFERENCES CITED IN THE DESCRIPTION

**Patent documents cited in the description**

- US 6360348 B1
- US 6353841 B
- US 20020157066 A